# EUROPÄISCHE PATENTSCHRIFT

(11) **EP 2 561 738 B1**
(45) Veröffentlichungstag und Bekanntmachung des Hinweises auf die Patenterteilung: **28.10.2015**
(21) Anmeldenummer: 11708280.0
(22) Anmeldetag: 15.03.2011
(51) Int. Cl.: H05K 7/20, B01D 46/00

(54) **FILTEREINHEIT FÜR EINEN SCHALTSCHRANK**
FILTER UNIT FOR A SWITCH CABINET
UNITÉ FILTRE POUR UNE ARMOIRE DE DISTRIBUTION

(30) Priorität: 19.04.2010 DE 102010016504
(43) Veröffentlichungstag der Anmeldung: 27.02.2013
(73) Patentinhaber: RITTAL GmbH & Co. KG, 35745 Herborn (DE)
(72) Erfinder: HARTMANN, Reiner, 35435 Wettenberg (DE); WAGNER, Steffen, 57299 Burbach (DE); SCHNEIDER, Stefan, 35080 Bad Endbach (DE)
(74) Vertreter: Angerhausen, Christoph
(86) Internationale Anmeldenummer: PCT/EP2011/053892
(87) Internationale Veröffentlichungsnummer: WO 2011/131424

(56) Entgegenhaltungen:
- EP-A1- 1 947 547
- DE-A1- 3 532 169
- DE-U1-202004 006 784
- US-A- 5 679 121

## Beschreibung

Die Erfindung betrifft eine Filtereinheit für einen Schaltschrank mit einem Filtergehäuse, das eine Luftdurchtrittsöffnung aufweist, die mit einem Luftdurchtrittsgitter zumindest teilweise überdeckbar ist, wobei das Luftdurchtrittsgitter an einem Filtergehäuse mittelbar oder unmittelbar anscharniert und zwischen einer Schließ- und einer geöffneten Wartungsposition verstellbar ist, und wobei das Filtergehäuse einen Halter aufweist, der in der Wartungsposition ein Fangstück des Luftdurchtritttsgitters formschlüssig blockiert. Eine derartige Filtereinheit ist aus der US 5,679,121 A bekannt. Eine ähnliche Filtereinheit beschreiben auch die DE 20 2004 006 784 U1 und die DE 35 32 169 A1.

Solche Filtereinheiten werden im Schaltschrankbau eingesetzt. Dabei ist in eine Schaltschrankwand ein Ausschnitt eingebracht, der mit der Filtereinheit überdeckt wird. Durch die Filtereinheit kann bspw. Umgebungsluft angesaugt und in den Schaltschrankinnenraum zu Kühlzwecken eingeleitet werden. Mit den Filtereinheiten sind häufig auch Ventilatorbaugruppen kombiniert, die am Filtergehäuse angeflanscht sind. Die Ventilatorbaugruppen fördern die Umgebungsluft aktiv in den Schaltschrankinnenraum hinein. Zur Vermeidung von Verschmutzungen im Innenraum des Schaltschrankes sind in den Filtergehäusen Filtermatten gehalten. Diese müssen, vor allem in Aufstellbereichen, mit starker Verschmutzung regelmäßig gewechselt werden. Hierzu wird das Luftdurchtrittsgitter von autorisiertem Fachpersonal abgenommen und beiseite gelegt. Anschließend wird die Filtermatte entnommen und gegen eine neue getauscht.

Es ist Aufgabe der Erfindung, eine Filtereinheit der eingangs erwähnten Art zu schaffen, bei der der Filtermattenwechsel wartungsfreundlich durchgeführt werden kann.

Diese Aufgabe wird durch eine Filtereinheit mit den Merkmalen des Patentanspruchs 1 gelöst. Die abhängigen Ansprüche 2 bis 7 betreffen jeweils vorteilhafte Ausführungsformen der Erfindung.

Erfindungsgemäß ist vorgesehen, dass der Halter eine Reibfläche aufweist, an der das Fangstück mit einer Gegen-Reibfläche aufläuft, so dass keine zusätzlichen Teile erforderlich werden. Zur Verbesserung der Betriebssicherheit ist weiterhin vorgesehen, dass der Halter zumindest in einem Teilbereich des Öffnungsweges federvorgespannt an dem Fangstück angepresst ist. Damit wird stets eine definierte Zuordnung zwischen Halter und Fangstück erreicht. Erfindungsgemäß sollen der Halter und das Fangstück jeweils einen hakenförmigen Ansatz aufweisen, die in der Wartungsposition ineinandergreifen. Über die hakenförmigen Geometrien finden sich der Halter und das Fangstück stets zuverlässig und bilden einen sicheren Formschluss in der Wartungsposition.

Für die Wartung der Filtereinheit kann ein Benutzer das Luftdurchtrittsgitter mittels der Scharnierverbindung aufklappen, sodass eine feste Zuordnung des Filtergehäuses und des Luftdurchtrittsgitters erhalten bleibt, und das Luftdurchtrittsgitter somit nicht separat abgelegt werden muss. Die Verstellbewegung des Luftdurchtrittsgitters ist mittels des Halters und mittels des Fangstückes blockiert. Sobald das Luftdurchtrittsgitter seine Wartungsposition erreicht hat, kommt das Fangstück mit dem Halter in Eingriff. Dann ist die Filtermatte zugänglich und kann bequem gewechselt werden. Dadurch, dass das Luftdurchtrittsgitter in eine definierte Wartungsposition gebracht wird, wird verhindert, dass die Filtermatte unbeabsichtigt auf den Boden fallen kann.

Gemäß einer bevorzugten Erfindungsvariante kann es vorgesehen sein, dass zwischen dem Luftdurchtrittsgitter und dem Filtergehäuse ein Dämpfer wirksam ist, der die Schwenkbewegung des Luftdurchtrittsgitters zumindest in einem Teilbereich des Öffnungsweges bremst. Auf diese Weise wird der Wartungsvorgang weiter dadurch optimiert, dass das Luftdurchtrittsgitter nicht ungebremst in die Wartungsposition fällt.

Eine einfache technische Gestaltung wird dabei dadurch erreicht, dass der Dämpfer ein Reibungsdämpfer ist.

Wenn vorgesehen ist, dass das Luftdurchtrittsgitter eine Mattenhalterung aufweist, an der eine Filtermatte auswechselbar gehalten ist, dann kann die Filtermatte zusammen mit dem Luftdurchtrittsgitter abgeklappt werden und ist dann für das Wartungspersonal bequem zugänglich.

Eine besonders bevorzugte Erfindungsausgestaltung sieht vor, dass das Luftdurchtrittsgitter das Fangstück im Bereich der Scharnierseite trägt. Auf diese Weise wird durch das Fangstück und den Halter die freie Zugänglichkeit zum Filtergehäuse nicht oder nur unerheblich eingeschränkt.

Eine optisch ansprechende Gestaltung wird dabei dadurch erreicht, dass das Luftdurchtrittsgitter eine Blende aufweist, die die Scharniere und den Halter sowie das Fangstück zur Frontseite hin optisch abdecken. Dabei kann die Blende einteilig an dem Luftdurchtrittsgitter angeformt sein, sodass ein geringer Teileaufwand erforderlich ist.

Gemäß einer weiteren Erfindungsvariante kann es vorgesehen sein, dass das Luftdurchtrittsgitter als Lamellengitter mit einer Vielzahl von konvex gewölbten Lamellen ausgebildet ist, und dass die Blende im Bereich der letzten Lamelle angeschlossen und ebenfalls konvex gewölbt ist. Damit integriert sich die Blende in das Design, das durch die Lamellen vorgegeben wird.

Die Erfindung wird im Folgenden anhand von in den Zeichnungen dargestellten Ausführungsbeispielen näher erläutert. Es zeigen:
- Figur 1: in perspektivischer Frontansicht und Explosionsdarstellung ein Wandelement eines Schaltschrankes mit einer Filtereinheit;
- Figur 2: die Darstellung gemäß Figur 1 in Zusammenbaudarstellung;
- Figur 3: eine Filtereinheit mit einem Luftdurchtrittsgitter in perspektivischer Frontansicht;
- Figur 4: die Filtereinheit gemäß Figur 3 in einer Wartungsposition;
- Figur 5: in vergrößerter Detaildarstellung einen Vertikalschnitt durch die Filtereinheit gemäß der Figur 5 in einer veränderten Montagestellung.

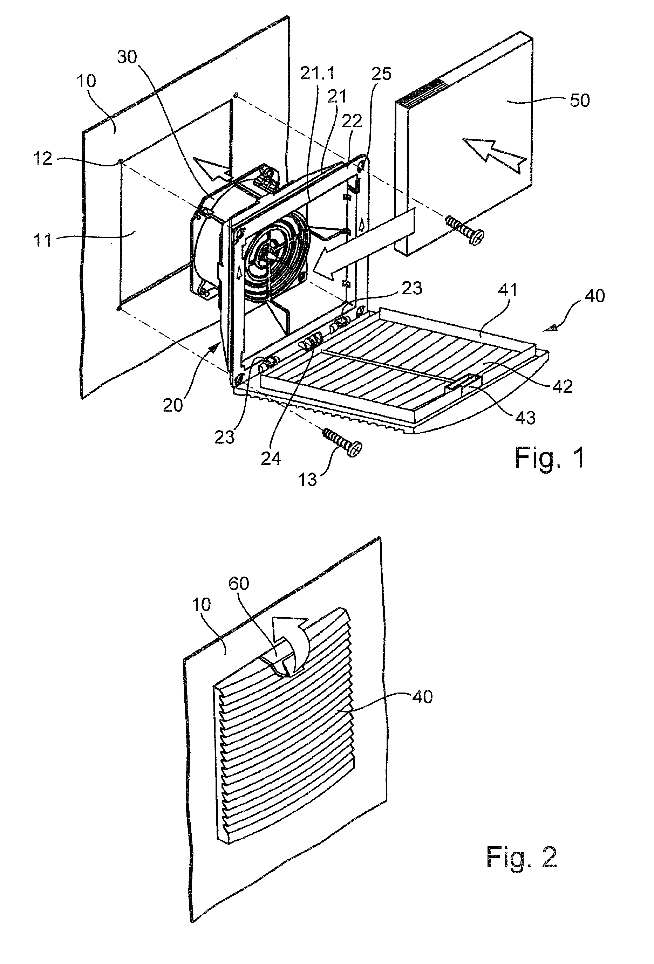

Figur 1 zeigt ein Wandelement 10 eines Schaltschrankes. Das Wandelement 10 ist typischerweise eine vertikale Seitenwand, eine Rückwand oder eine frontseitige Tür des Schaltschrankes. Das Wandelement 10 weist einen quadratischen Durchbruch 11 auf, dem in den Eckbereichen Schraubaufnahmen 12 zugeordnet sind. In den Durchbruch 11 kann eine Filtereinheit eingesetzt werden. Vorliegend weist die Filtereinheit ein Filtergehäuse 20 auf, das mit einer Gehäusewandung 21 einen Luftführungsbereich umschließt. Die Gehäusewandung 21 läuft in einem Boden 21.1 aus, der zur Durchleitung von Luft gitterartig ausgebildet ist. An den Boden 21.1 ist weiterhin eine Lüftereinheit 30 angeflanscht. Die Lüftereinheit 30 umfasst einen Elektromotor und einen Ventilator, der dazu vorgesehen ist, Umgebungsluft anzusaugen und in den Schaltschrankinnenraum einzublasen, wie dies durch die Pfeildarstellung in Figur 1 symbolisiert wird. Der Lüftereinheit 30 abgekehrt ist an die Gehäusewandung 21 ein umlaufender Bund 22 angeformt. Mittels des Bundes 22 kann die Einsetzbewegung des Filtergehäuses 20 in den Durchbruch 11 begrenzt werden. Dabei liegt dann der Bund 22 frontseitig um den Durchbruch 11 herum auf dem Wandelement 10 auf. Der Bund 22 weist in seinen Eckbereichen Schraubaufnahmen 25 auf. Durch diese können Befestigungsschrauben 13 hindurchgeführt und in die Schraubaufnahmen 12 des Wandelementes 10 eingeschraubt werden. Auf diese Weise ist das Filtergehäuse 20 fest mit dem Wandelement 10 verbunden.

Wie die Figur 1 weiter erkennen lässt, ist mit dem Filtergehäuse 20 ein Luftdurchtrittsgitter 40 verbunden. Das Luftdurchtrittsgitter 40 ist dabei über zwei Scharniere 23 an seinem unteren horizontalen Rand mit dem unteren horizontalen Rand des Filtergehäuses 20 gekoppelt. Die Scharniere 23 bilden eine horizontale Scharnierachse, um die das Luftdurchtrittsgitter 40 zwischen einer senkrechten Montageposition und einer, aus Figur 1 ersichtlichen abgeklappten Wartungsposition, verstellbar ist.

Das Luftdurchtrittsgitter 40 weist drei aneinander geschlossene Wände auf, die als Mattenhalterung 41 für eine Filtermatte 50 verwendet sind. In die Mattenhalterung 41 kann die Filtermatte 50 eingelegt werden. Dabei stützt sich die Filtermatte 50 mit ihrer Vorderseite auf Lamellen 42 des Luftdurchtrittsgitters 40 ab. Die Lamellen 42 bilden Lufteintrittsöffnungen, durch die Umgebungsluft durch die Filtermatte 50 hindurch in das Filtergehäuse 20 und die Lüftereinheit 30 in den Schaltschrankinnenraum befördert werden kann.

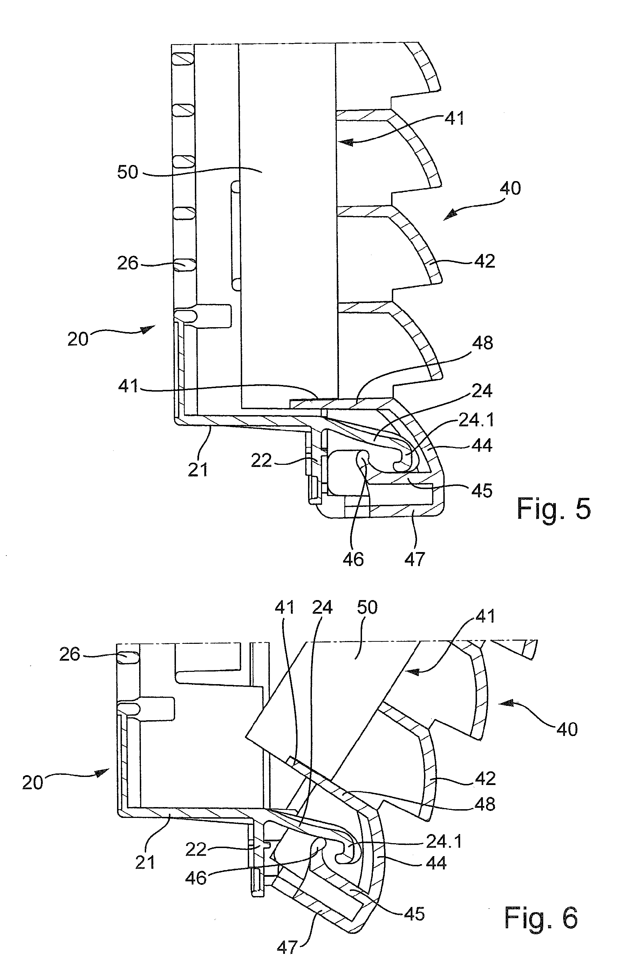

Zwischen dem Luftdurchtrittsgitter 40 und dem Filtergehäuse 20 ist eine Fangvorrichtung wirksam, die das Luftdurchtrittsgitter 40 in der Wartungsposition, die aus Figur 1 erkennbar ist, hält. Hierbei ist ein Halter 24 am Filtergehäuse 20 einteilig angeformt, der mit einem Fangstück 46 in Eingriff kommt. Die Zuordnung des Halters 24 zu dem Fangstück 46 wird später mit Bezug auf Figur 5 bzw. 6 näher erläutert.

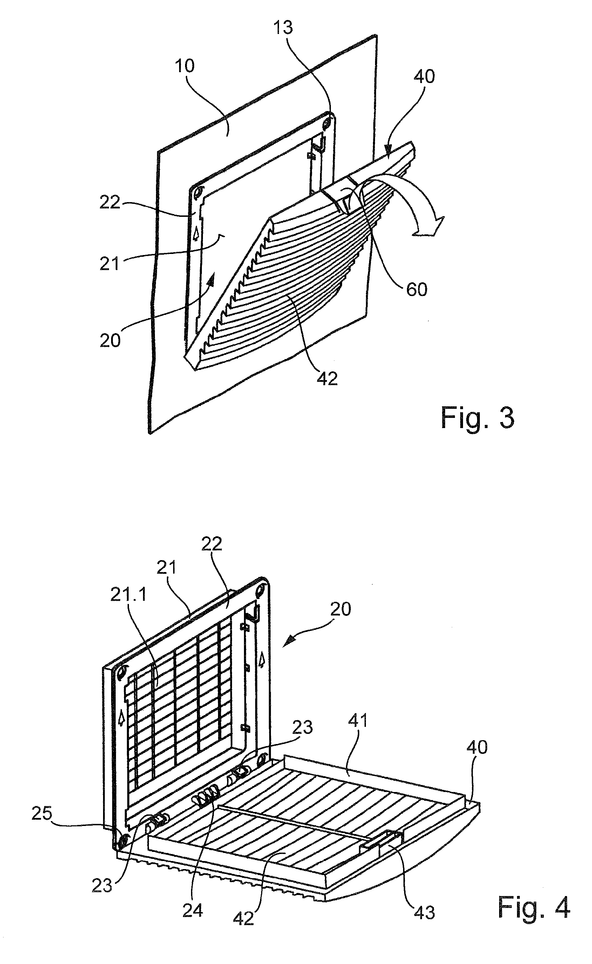

Wenn das Luftdurchtrittsgitter 40 in seiner Wartungsposition steht, kann eine Filtermatte 50 eingesetzt werden. Anschließend wird das Luftdurchtrittsgitter 40 in seine vertikale Lage verschwenkt, wie dies die Figur 2 erkennen lässt. Am oberen horizontalen Rand des Luftdurchtrittsgitters 40 ist ein Verriegelungsmechanismus 60 vorgesehen, mit dem das Luftdurchtrittsgitter 40 lösbar an dem Filtergehäuse 20 festlegbar ist. Wenn diese Verriegelungsanordnung 60 gelöst wird (siehe Pfeildarstellungen gemäß Figur 2), dann kann das Luftdurchtrittsgitter 40 wieder in eine Wartungsposition abgeklappt werden, wie dies die Figur 3 veranschaulicht.

In den Figuren 4 bis 6 ist eine weitere Ausgestaltungsvariante der Erfindung dargestellt. Dabei ist die Ausgestaltung des Luftdurchtrittsgitters 40 identisch mit der gemäß den Figuren 1 bis 3. Als Filtergehäuse 20 wird ein Durchtrittsgehäuse verwendet, an das keine Lüftereinheit 30 angeflanscht ist. Vielmehr weist das Filtergehäuse 20 eine Gehäusewandung 21 auf, die mit einem Boden mit Gitter 21.1 abgeschlossen ist. Weiterhin ist identisch zu der Ausgestaltung gemäß den Figuren 1 bis 3 ein Bund 22 vorgesehen, der an einem Durchbruch 11 eines Wandelementes 10 (gemäß Figur 1) festgelegt werden kann, wie dies vorstehend bereits beschrieben wurde. Identisch zu der Ausgestaltung gemäß den Figuren 1 bis 3 sind wieder zwei Scharniere 23, ein Halter 24 und ein Fangstück 46 im Scharnierbereich vorgesehen.

Nachfolgend wird unter Bezugnahme auf die Figuren 5 und 6 näher auf die Zuordnung, welche durch das Fangstück 46 und den Halter 24 gebildet ist, eingegangen. An dieser Stelle wird darauf verwiesen, dass die Ausgestaltung dieses Bereichs bei den beiden Ausführungsvarianten gemäß den Figuren 1 bis 3 bzw. 4 bis 6 identisch ist.

Demgemäß ist an der Gehäusewandung 21 im Bereich des unteren horizontal verlaufenden Bundes 22 der Halter 24 einteilig angeformt. Dabei ist der Halter 24 derart ausgestaltet, dass er eine blattfederartige Geometrie bildet. An seinem freien Ende weist der Halter 24 einen Hakenansatz 24.1 auf. Das Luftdurchtrittsgitter 40 ist im Bereich eines unteren horizontalen Wandelements 48, das zugleich den unteren Teil der Mattenhalterung 41 bildet, abgeschlossen. Das Wandelement 48 trägt eine konvex gewölbte Blende. Dabei ist die Wölbung identisch mit der Wölbung der Lamellen 42 ausgeführt, sodass die Blende 44 optisch die Form einer Lamelle 42 nachahmt.

Innenseitig ist an der Blende 44 ein Steg 45 angeformt, der einteilig das hakenförmige Fangstück 46 trägt. Wenn nun das Luftdurchtrittsgitter 40 ausgehend aus seiner in Figur 5 dargestellten Betriebsposition in den Scharnieren 23 abgeklappt wird, so erreicht es nach einem gewissen Verstellwinkel die Position gemäß Figur 6. Dann trifft das Fangstück 46 auf den Halter 24. Da nun der Halter 24 über ein Federelement an die Gehäusewandung 21 angeformt ist, wird er federelastisch nach oben ausgelenkt und übt dabei eine Anpresskraft auf das Fangstück 46 aus. Auf diese Weise entsteht bei einer weiteren Verschwenkung des Lamellengitters eine Bremswirkung zwischen dem Fangstück 46 und dem Halter 24, wobei eine Reibungsfläche des Halters 24 an einer Gegenreibungsfläche des Fangstücks 46 entlang gleitet. Hierdurch wird eine Bremskraft erzeugt, die der Abklappbewegung des Luftdurchtrittsgitters 40 entgegenwirkt. Die Schwenkbewegung des Luftdurchtrittsgitters 40 wird mit dem Hakenansatz 24.1 des Halters 24 begrenzt. Wenn die Wartungsposition erreicht ist, dann greift das Fangstück 46 in den Hakenansatz 24.1 formschlüssig ein und verhindert so ein weiteres Abklappen des Luftdurchtrittsgitters 40. Das Luftdurchtrittsgitter 40 befindet sich dann in der in Figur 1 bzw. Figur 4 gezeigten Stellung. In dieser Wartungsposition kann die Filtermatte 50 bequem gewechselt werden.

## Patentansprüche

1. Filtereinheit für einen Schaltschrank, mit einer Filtermatte (50) und mit einem mit einem Wandelement eines Schaltschranks fest verbundenen Filtergehäuse (20), das eine Luftdurchtrittsöffnung aufweist, die mit einem Luftdurchtrittsgitter (40) zumindest teilweise überdeckt ist, wobei eine Scharnierverbindung zwischen dem Luftdurchtrittsgitter (40) und dem Filtergehäuse (20) ausgebildet ist, so dass das Luftdurchtrittsgitter (40) zwischen einer Schliess- und einer geöffneten Wartungsposition verstellbar ist, wobei das Filtergehäuse (20) einen über ein Federelement angeformten Halter (24) aufweist, der in der Wartungsposition ein Fangstück (46) des Luftdurchtrittsgitters (40) formschlüssig blockiert, wobei das Luftdurchtrittsgitter (40) bei einem gewissen Verstellwinkel eine Position erreicht, bei der das Fangstück (46) auf den Halter (24) trifft, wobei bei weiterer Verschwenkung eine Reibungsfläche des Halters (24) an einer Gegenreibungsfläche des Fangstücks (46) entlanggleitet und der Halter (24) durch das Fangstück (46) federelastisch ausgelenkt wird, wobei eine Anpresskraft auf das Fangstück (46) ausgeübt wird, und wobei der Halter (24) und das Fangstück (46) jeweils einen hakenförmigen Ansatz (24.1) aufweisen, die in der Wartungsposition ineinandergreifen.

2. Filtereinheit nach Anspruch 1 ,
**dadurch gekennzeichnet,**
**dass** zwischen dem Luftdurchtrittsgitter (40) und dem Filtergehäuse (20) ein Dämpfer wirksam ist, der die Schwenkbewegung des Luftdurchtrittsgitters (40) zumindest in einem Teilbereich des Öffnungsweges bremst.

3. Filtereinheit nach Anspruch 1,
**dadurch gekennzeichnet,**
**dass** der Dämpfer ein Reibungsdämpfer ist.

4. Filtereinheit nach einem der Ansprüche 1 bis 3,
**dadurch gekennzeichnet,**
**dass** das Luftdurchtrittsgitter (40) eine Mattenhalterung (41) aufweist, an der eine Filtermatte (50) auswechselbar gehalten ist.

5. Filtereinheit nach einem der Ansprüche 1 bis 4,
**dadurch gekennzeichnet,**
**dass** das Luftdurchtrittsgitter (40) das Fangstück (46) an der Scharnierseite trägt.

6. Filtereinheit nach Anspruch 5,
**dadurch gekennzeichnet,**
**dass** das Luftdurchtrittsgitter (40) eine Blende (44) aufweist, die die Scharniere (23) und den Halter (24) sowie das Fangstück (46) zur Frontseite hin optisch abdeckt.

7. Filtereinheit nach einem der Ansprüche 1 bis 6,
**dadurch gekennzeichnet,**
**dass** das Luftdurchtrittsgitter (40) als Lamellengitter mit einer Vielzahl von konvex gewölbten Lamellen (42) ausgebildet ist, und dass die Blende (44) im Bereich der letzten Lamelle (42) angeschlossen und ebenfalls konvex gewölbt ist.

## Claims

1. A filter unit for a switchgear cabinet, comprising a filter mat (50) and a filter housing (20) permanently fixed to a wall element of a switchgear cabinet and having an air passage that can be covered by an air passage grating (40) at least to some extent, wherein a hinge-joint in formed between the air passage grating (40) and the filter housing (20), so that the air passage grating (40) can be adjusted between a closed position and an opened maintenance position,
wherein the filter housing (20) has a retainer (24) formed via a spring element and which positively blocks a catch (46) of the air passage grating (40) in the maintenance position, wherein said air passage grating (40), wherein, at a specific adjustment angle, the air passage grating reaches a position, in which the catch (46) meets retainer (24), wherein upon further deviation a friction surface of the retainer (24) slides along a counter friction surface of the catch (46) and the retainer (24) is elastically deflected by the catch (46), wherein a pressure force is applied to catch (46), and wherein each of retainer (26) and catch (46) comprise a hook tab (24.1), that engage each other in the maintenance position.

2. The air filter unit of claim 1, **characterized in that** a damper is effective between the air passage grating (40) and the filter housing (20) which at least in a part of the opening stroke decelerates the pivoting motion of the air passage grating (40).

3. The air filter unit of claim 2, **characterized in that** the damper is a friction damper.

4. The air filter unit of any of claims 1 to 3, **characterized in that** the air passage grating (40) comprises a mat holder (40) retaining a filter mat (50) replaceably.

5. The air filter unit of any of claims 1 to 4, **characterized in that** the air passage grating (40) carries the catch (46) at the hinge side.

6. The air filter unit of claim 5, **characterized in that** the air grating passage (40) comprises a shield (44) optically covering the hinges (23) and holder (24) and catch (46) to the front side.

7. The air filter unit of any of claims 1 to 6, **characterized in that** the air passage grating (40) is formed as a louvered grille having a plurality of convexly curved louvers (42) and that the shield (44) adjoins in the region of the last louver (42) and is also convexly curved.

## Revendications

1. Unité de filtrage pour une armoire électrique, comportant un tapis filtrant (50) et comportant un boîtier (20), qui est relié de manière fixe à un élément de paroi d'une armoire électrique et qui comporte une ouverture de passage d'air qui est recouverte au moins en partie par une grille de passage d'air (40), une liaison par charnière étant réalisée entre la grille de passage d'air (40) et le boîtier (20), de telle sorte que la grille de passage d'air (40) peut être réglée entre une position de fermeture et une position de maintenance ouverte, le boîtier (20) comportant un support (24), qui est formé au-dessus d'un élément de ressort et qui, dans la position de maintenance, bloque par conjugaison de forme un élément d'arrêt (46) de la grille de passage d'air (40), la grille de passage d'air (40), dans un angle de réglage déterminé, atteignant une position dans laquelle l'élément d'arrêt (46) vient buter sur le support (24), en cas de poursuite du pivotement, une surface de frottement du support (24) glisse le long d'une surface de frottement antagoniste de l'élément d'arrêt (46) et le support (24) est dévié élastiquement par l'élément d'arrêt (46), une force d'appui étant appliquée sur l'élément d'arrêt (46), et le support (24) et l'élément d'arrêt (46) comportant chacun une saillie (24.1) en forme de crochet, lesquelles s'engagent l'une dans l'autre dans la position de maintenance.

2. Unité de filtrage selon la revendication 1, **caractérisée en ce qu'**un amortisseur agit entre la grille de passage d'air (40) et le boîtier (20), lequel freine le mouvement de pivotement de la grille de passage d'air (40) au moins dans une zone partielle de la trajectoire d'ouverture.

3. Unité de filtrage selon la revendication 1, **caractérisée en ce que** l'amortisseur est un amortisseur par frottement.

4. Unité de filtrage selon l'une quelconque des revendications 1 à 3, **caractérisée en ce que** la grille de passage d'air (40) comporte un support (41), contre lequel le tapis filtrant (50) est maintenu de manière amovible.

5. Unité de filtrage selon l'une quelconque des revendications 1 à 4, **caractérisée en ce que** la grille de passage d'air (40) porte l'élément d'arrêt (46) sur le côté de la charnière.

6. Unité de filtrage selon la revendication 5, **caractérisée en ce que** la grille de passage d'air (40) comporte un cache (44), par lequel la charnière (23) et le support (24), ainsi que l'élément d'arrêt (46) sont masqués optiquement vers la face frontale.

7. Unité de filtrage selon l'une quelconque des revendications 1 à 6, **caractérisée en ce que** la grille de passage d'air (40) est réalisée sous la forme d'une grille à lamelles avec une pluralité de lamelles (42) à courbure convexe, et **en ce que** le cache (44) est raccordé dans la zone de la dernière lamelle (42) et présente également une courbure convexe.
